# EUROPEAN PATENT SPECIFICATION

(11) **EP 0 747 850 B1**
(45) Date of publication and mention of the grant of the patent: **20.03.2002**
(21) Application number: 95108919.2
(22) Date of filing: 09.06.1995
(51) Int. Cl.: G06G 7/195, H03H 9/42

(54) **Surface acoustic wave device and communication system using the same**
Akustische Oberflächenwellenanordnung und diese verwendendes Übertragungssystem
Dispositif à ondes acoustiques de surface et système de communication utilisant ce dispositif

(43) Date of publication of application: 11.12.1996
(73) Proprietor: CANON KABUSHIKI KAISHA, Tokyo (JP)
(72) Inventor: Mochizuki, Norihiro, Ohta-ku, Tokyo (JP); Torisawa, Akira, Ohta-ku, Tokyo (JP); Egara, Koichi, Ohta-ku, Tokyo (JP); Eguchi, Tadashi, Ohta-ku, Tokyo (JP); Koyama, Akihiro, Ohta-ku, Tokyo (JP); Hachisu, Takahiro, Ohta-ku, Tokyo (JP)
(74) Representative: Tiedtke, Harro, Dipl.-Ing.

(56) References cited:
- US-A- 4 388 599

## Description

### BACKGROUND OF THE INVENTION

### Field of the Invention

This invention relates to a surface acoustic wave device, and particularly to a surface acoustic device having a waveguide for guiding a surface acoustic wave, output means for taking out a signal generated by the waveguide, and a junction portion electrically connecting the waveguide and the output means together. The invention also relates to a communication system using the surface acoustic device.

### Related Background Art

A surface acoustic wave device, particularly a surface acoustic wave convolver, is a signal processing device which effects the convolution calculation of two signals, and in recent years, attention has been paid to it as the key device of a spread spectrum communication system.

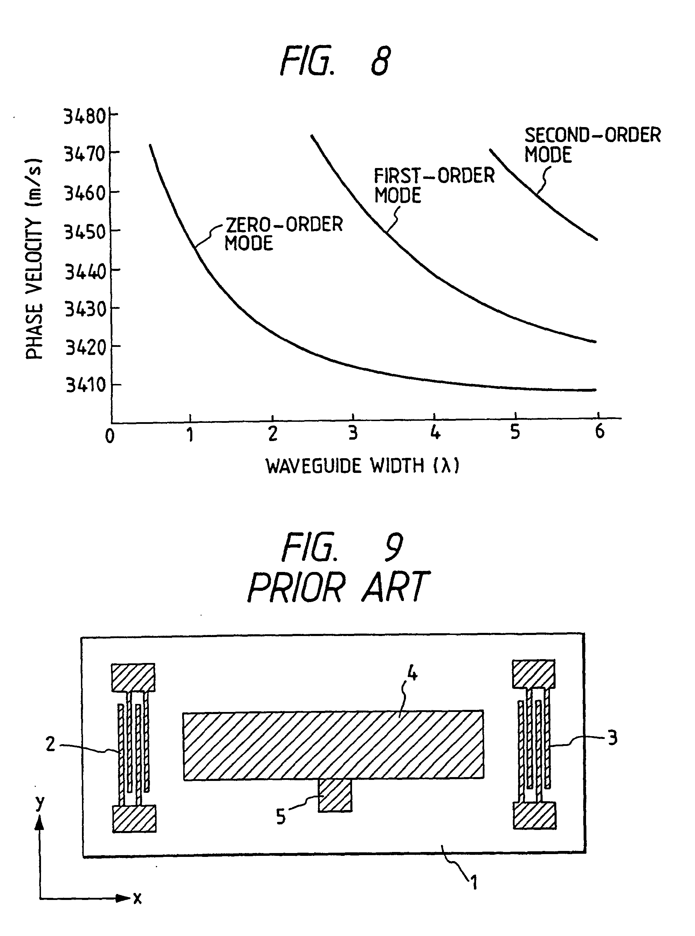

Figure 9 of the accompanying drawings is a schematic plan view showing the construction of a surface acoustic wave device according to the prior art. In Figure 9, the reference numeral 1 designates a piezoelectric substrate, and the reference numerals 2 and 3 denote two surface acoustic wave exciting electrodes formed on the surface of the substrate 1 with a suitable distance therebetween. The reference numeral 4 designates a surface acoustic wave waveguide formed on the surface of the substrate 1 between the electrodes 2 and 3, and the reference numeral 5 denotes an output tap for electrically taking out a signal generated by the surface acoustic wave waveguide 4.

In this surface acoustic wave device, when an electrical signal of a suitable angular frequency ω is inputted to the surface acoustic wave exciting electrodes 2 and 3, surface acoustic waves are excited and the surface acoustic waves propagate through the surface acoustic wave waveguide 4 in opposite directions, and an electrical signals of the product component of two signals is generated at an angular frequency 2ω in the surface acoustic wave waveguide 4 by a parametric mixing phenomenon. The surface acoustic wave waveguide 4 is formed of an electrically conductive material and it acts also as an output electrode, and the electrical signals generated in the surface acoustic wave waveguide 4 are combined and are taken out from the output tap 5 electrically connected to the surface acoustic wave waveguide 4, through a wire or the like.

Such a surface acoustic wave device is known from Literature 1 (Handbook of Acoustic Wave Element Technique, edited by the 150th Committee of Acoustic Wave Element Technique, the Japan Society for the Promotion of Science, and published by Ohm Co., Ltd., 246-250 (1991)).

Also, a device improved over such a surface acoustic wave device is proposed by Literature 2 (FR-8011225 and corresponding U.S. Patent 4,388,599 and corresponding Japanese Patent Publication No. 3-1847).

In Literature 2, when a signal generated in the surface acoustic wave waveguide is to be taken out, in order to suppress the deterioration of the signal caused by the time difference until this signal arrives at an output taking-out port, the signal is taken out from a plurality of portions of the surface acoustic wave waveguide and further, in order that the output taking-out port may not hinder the propagation of the surface acoustic wave propagating through the surface acoustic wave waveguide, an electrode junction portion which is in contact with the surface acoustic wave waveguide is formed so as not to be wider than λₐ/5, where λₐ is the wavelength of the surface acoustic wave.

However, in the example of the prior art shown in the above-described Literature 2, the electrode junction portion which is in contact with the surface acoustic wave waveguide is made equal to or narrower than λₐ/5, and this has led to the problem that when the frequency becomes high, the line width of the electrode junction portion becomes very small (for example, when the central frequency of an input signal is 200MHz, the velocity of the surface acoustic wave is 1500 to 4000 m/s and therefore the junction portion is 1.5 to 4 µm) and the resistance in the electrode junction portion cannot be neglected and the output is reduced.

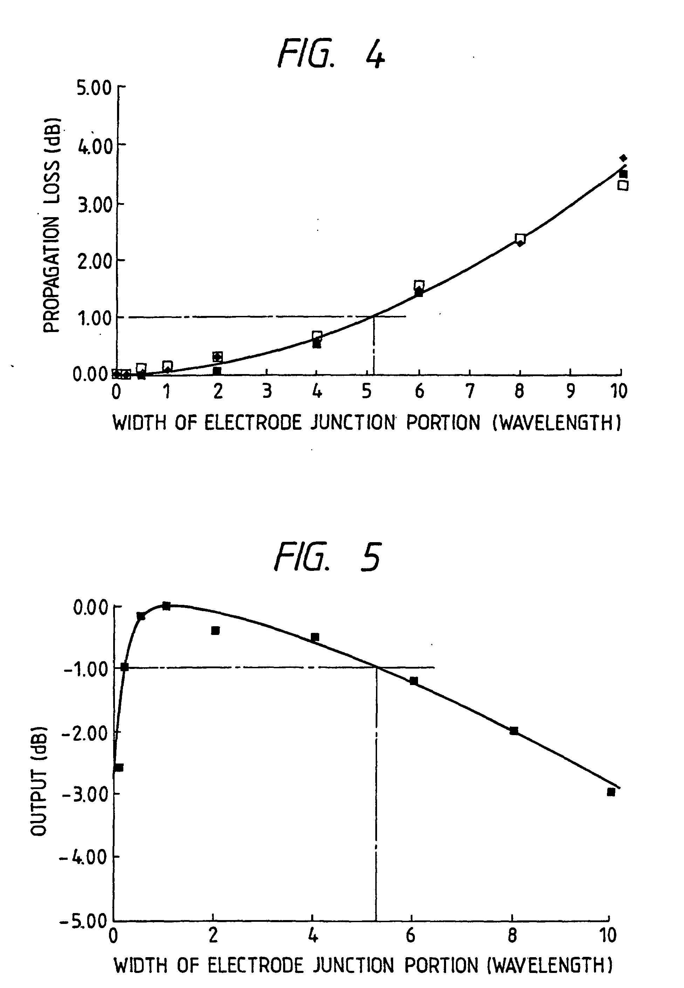

Here, when as an example, the width of the surface acoustic wave waveguide is about 2.5 times the wavelength of the surface acoustic wave and eight electrode junction portions 6 are provided along and on the opposite sides of the surface acoustic wave waveguide 4, the result (relative value) of the output having been measured when the width of the electrode junction portions 6 has been varied is shown in Figure 5 of the accompanying drawings. Here, the result of the measurement is represented by a relative value with the case where the width of the electrode junction portions 6 is made equal to the wavelength (λₐ) of the surface acoustic wave as the standard. It can be seen from Figure 5 that when the width of the electrode junction portions 6 is not made wider than λₐ/5, the output is greatly reduced.

Further, the line width of the electrode junction portions is very small, and this has led to the problem that disconnection is liable to occur and the yield is deteriorated.

### SUMMARY OF THE INVENTION

It is the object of the present invention to realize a surface acoustic wave device in which the propagation loss of a surface acoustic wave propagating on a surface acoustic wave waveguide is not increased and the reduction in output by the electrical resistance of a junction portion is small. To this end, in the present invention, a surface acoustic wave device and a communication system are constructed as follows.

A surface acoustic wave device comprises a substrate having a piezoelectric property, surface acoustic wave exciting means formed on said substrate, a waveguide for guiding a surface acoustic wave excited by said exciting means, output means for taking out a signal generated by said waveguide, and a junction portion electrically connecting said waveguide and said output means together, and is characterized in that the width of that portion of said junction portion which is in contact with said waveguide is greater than 0.2 time and equal to or less than 5 times the wavelength of the surface acoustic wave excited by said exciting means.

A communication system for transmitting a spread spectrum signal comprises a transmitter for transmitting the spread spectrum signal, and a receiver having a surface acoustic wave device for obtaining the convolution signal of the inputted spread spectrum signal and a reference signal, and is characterized in that said surface acoustic wave device comprises a substrate having a piezoelectric property, surface acoustic wave exciting means formed on said substrate for exciting a surface acoustic wave corresponding to the received spread spectrum signal, surface acoustic wave exciting means formed on said substrate for exciting a surface acoustic wave corresponding to the reference signal, a waveguide for guiding the surface acoustic wave corresponding to the spread spectrum signal and the surface acoustic wave corresponding to the reference signal excited by said exciting means in opposite directions, output means for taking out a signal generated by said waveguide, and a junction portion connecting said waveguide and said output means together, wherein the width of that portion of said junction portion which is in contact with said waveguide is greater than 0.2 time but not greater than 5 times the wavelength of the surface acoustic waves excited by said exciting means.

### BRIEF DESCRIPTION OF THE DRAWINGS

Figure 1 is a schematic plan view showing a first embodiment of a surface acoustic wave device according to the present invention.

Figure 2 is a fragmentary enlarged view of the first embodiment.

Figure 3 is a graph showing the amplitude distribution of a surface acoustic wave propagating through a surface acoustic wave waveguide.

Figure 4 is a graph showing the relation between the width of an electrode junction portion and propagation loss.

Figure 5 is a graph showing the relation between the width of the electrode junction portion and the output.

Figure 6 shows a second embodiment of the surface acoustic wave device according to the present invention.

Figure 7 shows a third embodiment of the surface acoustic wave device according to the present invention.

Figure 8 is a graph showing the relation between the width of the waveguide and the phase velocity of each waveguide mode.

Figure 9 shows an example of the prior art.

Figure 10 shows an embodiment of a communication system using the surface acoustic wave device according to the present invention.

Figure 11 shows a transmitter in another embodiment of the communication system using the surface acoustic wave device according to the present invention.

Figure 12 shows a receiver in another embodiment of the communication system using the surface acoustic wave device according to the present invention.

### DESCRIPTION OF THE PREFERRED EMBODIMENTS

### [First Embodiment]

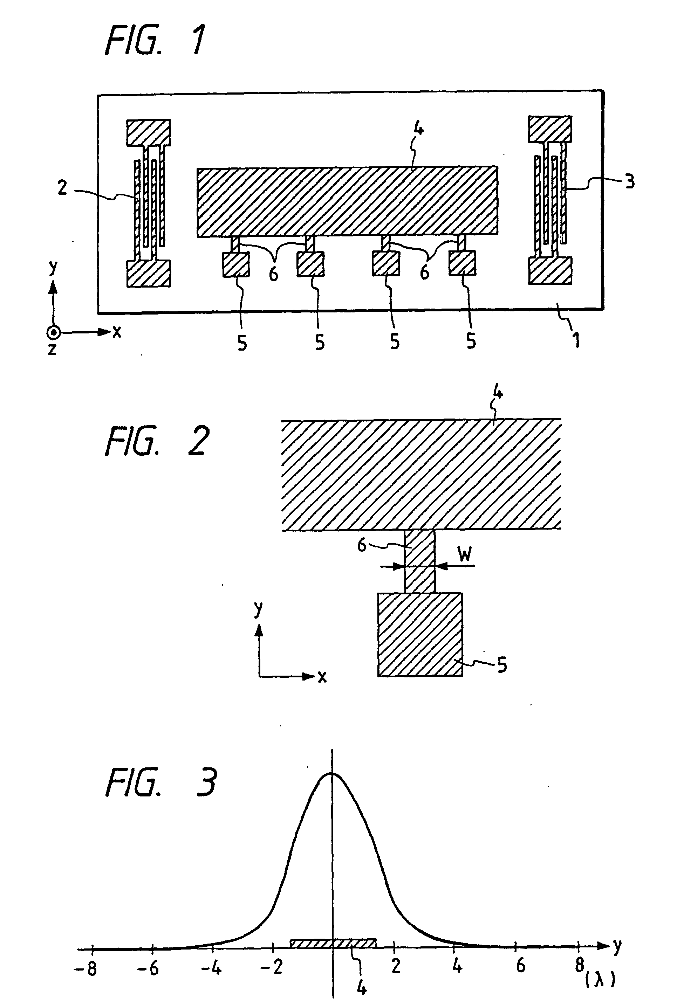

Figure 1 is a schematic plan view showing a first embodiment of a surface acoustic wave device according to the present invention. Figure 2 is a fragmentary enlarged view of the first embodiment shown in Figure 1.

In Figure 1, reference numeral 1 designates a piezoelectric substrate. As the piezoelectric substrate, use can be made, for example, a piezoelectric substrate of lithium niobate or the like.

Reference numerals 2 and 3 denote surface acoustic wave exciting electrodes formed on the surface of the substrate 1 with a suitable distance therebetween. These electrodes 2 and 3 are interdigital transducers and are formed of an electrically conductive material such as aluminum, silver or gold.

Reference numeral 4 designates a surface acoustic wave waveguide formed between the electrodes 2 and 3. The surface acoustic wave waveguide 4 is formed of an electrically conductive material such as aluminum, silver or gold.

Reference numeral 5 denotes output pads as output means for electrically taking out a signal generated in the surface acoustic wave waveguide 4.

Reference numeral 6 designates electrode junction portions connecting the surface acoustic wave waveguide 4 and the output pads 5 together. In the present embodiment, the wavelength of a surface acoustic wave excited by the surface acoustic wave exciting electrode 2 or 3 is λₐ and the width w (Figure 2) of the electrode junction portions 6 is greater than 0.2λₐ but not greater than 5λₐ.

In Figures 1 and 2, in order to make the illustration readily understood, the direction in which a first surface acoustic wave propagates through the surface acoustic wave waveguide 4 is defined as x, the direction of the normal to the surface of the substrate 1 is defined as z, and the direction of the normal to xz plane is defined as y. These x, y and z do not mean the crystal axis of the substrate.

In the surface acoustic wave device of the present embodiment, when an electrical signal of a central angular frequency ω conforming to the characteristic of one exciting electrode 2 is inputted to the exciting electrode 2, a first surface acoustic wave is excited and enters the surface acoustic wave waveguide 4. Also, when an electrical signal of a central angular frequency ω conforming to the characteristic of the other exciting electrode 3 is inputted to the exciting electrode 3 in the same manner, a second surface acoustic wave is excited and enters the surface acoustic wave waveguide 4 from the direction opposite to the first surface acoustic wave. The first and second surface acoustic waves propagate through the surface acoustic wave waveguide 4 from the opposite ends thereof in opposite directions and electrical signals of a central angular frequency 2ω are generated in the surface acoustic wave waveguide 4 by the parametric mixing phenomenon. The surface acoustic wave waveguide 4, which is formed of an electrically conductive material, acts also as an output electrode, and these electrical signals are combined on the surface acoustic wave waveguide 4 and are taken out from the output pads 5 through the electrode junction portions 6.

Here, the surface acoustic wave waveguide 4 functions as a waveguide due to the difference between the velocity (Vm) of the surface acoustic wave propagating on the surface of which the electric field is short-circuited by the electrically conductive material and the velocity (Vo) of the surface acoustic wave propagating on the free surface, but the difference between Vo and Vm is slight and therefore, when the first and second surface acoustic waves propagate through the surface acoustic wave waveguide 4, energy spreads to the surface shown in Figure 3 which is not covered with the electrically conductive material. Figure 3 shows amplitude distribution in a direction (direction y) orthogonal to the direction of propagation of the surface acoustic waves propagating through the surface acoustic wave waveguide 4. Such surface acoustic waves usually propagate through the surface acoustic wave waveguide 4 with low loss, but in the portions wherein the electrode junction portions 6 are connected to the surface acoustic wave waveguide 4, the width of the waveguide looks as if it widened and therefore, the surface acoustic wave energy spreads in the widthwise direction (direction y) of the surface acoustic wave waveguide and propagation loss increases.

When as an example, the width of the surface acoustic wave waveguide is about 2.5 times the wavelength of the surface acoustic wave and the electrode junction portions 6 are provided at eight locations along and on the opposite sides of the surface acoustic wave waveguide 4, the result (relative value) of the propagation loss having been measured when the width w of the electrode junction portions 6 is varied is shown in Figure 4. Here, the result of the measurement is represented by a relative value with a case where the electrode junction portions are absent as the standard. It is seen from Figure 4 that as the width w of the electrode junction portions 6 is increased, propagation loss increases, and when the width w of the electrode junction portions 6 is made equal to or smaller than 5λₐ, the propagation loss by the electrode junction portions can be suppressed to 1dB or less.

Also, it is desirable that the width w of the electrode junction portions 6 be made equal to or smaller than 5λₐ until the energy of the surface acoustic wave becomes sufficiently small in the direction y, and it is desirable that any other electrically conductive material than the surface acoustic wave waveguide 4 and the electrode junction portions 6 be not present within a range occupying at least 99% of the whole energy of the surface acoustic wave in the direction y in an area near the surface acoustic wave waveguide 4.

Also, from the aforedescribed Figure 5, it is apparent that by the width w of the electrode junction portions 6 being greater than 0.2λₐ but not greater than 5λₐ, the reduction in output can be suppressed to within 1dB.

Accordingly, by the width w of the electrode junction portions being limited to be greater than 0.2λₐ but not greater than 5λₐ, the propagation loss in the electrode junction portions can be suppressed and further, the reduction in output can be suppressed.

### [Second Embodiment]

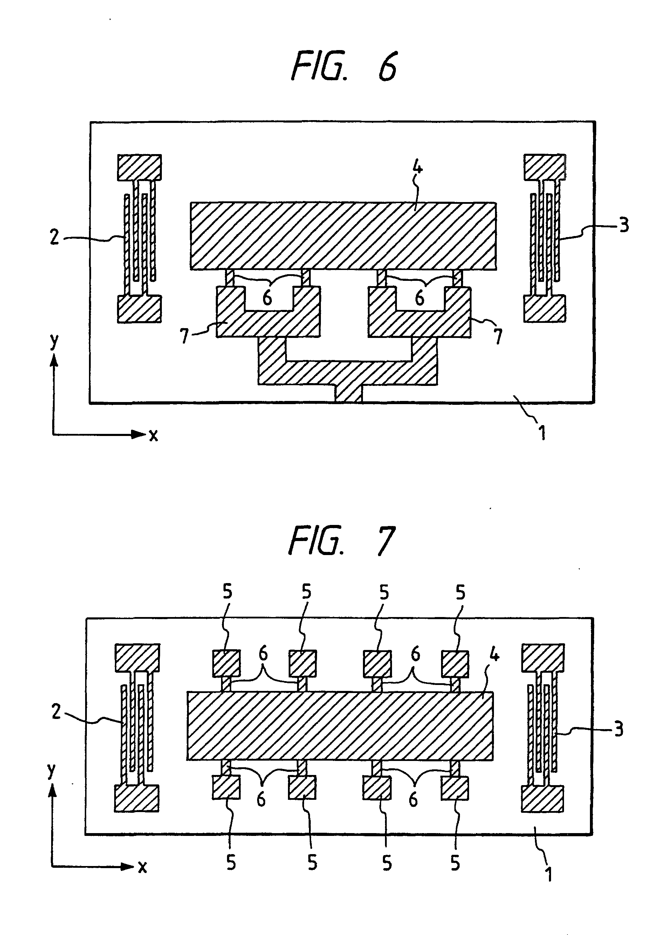

Figure 6 is a schematic plan view showing a second embodiment of the surface acoustic wave device according to the present invention. In Figure 6, the same members as those in the above-described first embodiment are given the same reference numerals. This embodiment differs from the first embodiment only in that transmission lines 7 are formed on the substrate 1 and the transmission lines 7 and the electrode junction portions 6 are electrically connected together.

Again the present embodiment has an operational effect similar to that of the first embodiment, but in the present embodiment, the outputs from the plurality of electrode junction portions 6 can be combined by the transmission lines 7 and a circuit element of inductance, capacitance or the like can be formed on the substrate 1 and therefore, the number of circuits around the surface acoustic wave device can be decreased.

### [Third Embodiment]

Figure 7 is a schematic plan view showing a third embodiment of the surface acoustic wave device according to the present invention. In Figure 7, the same members as those in the above-described first embodiment are given the same reference numerals. This embodiment differs from the first embodiment only in that the electrode junction portions 6 are provided symmetrically with respect to the center line of the surface acoustic wave waveguide 4 in the direction in which the first surface acoustic wave propagates.

Again the present embodiment has an operational effect similar to that of the first embodiment, but in the present embodiment, the electrode junction portions 6 are provided symmetrically with respect to the surface acoustic wave waveguide 4, and this leads to the following effect.

In the surface acoustic wave device of the present invention, to enhance the output, design is generally made such that the width of the surface acoustic wave waveguide 4 is made small and the energy of the surface acoustic wave is much concentrated therein. Methods of concentrating energy in the narrow surface acoustic wave waveguide 4 heretofore proposed include a method of giving a dispersing property to a narrow exciting electrode, a method of exciting a surface acoustic wave of a great beam width from a wide exciting electrode, and compressing the beam width by a multistrip coupler or a horn type waveguide, and a method of curving an exciting electrode into an arcuate shape or the like and compressing the beam width. These methods can be used in the present embodiment as well as in the first and second embodiments.

However, when the width of the surface acoustic wave waveguide 4 is small, the velocity difference depending on the waveguide mode for propagating is great and therefore, to make the frequency characteristic good, it is desirable that the mode for propagating through the surface acoustic wave waveguide 4 be single, i.e., be a single mode. Figure 8 shows, as an example, the relation between the waveguide width in a y-cut z-propagation lithium niobate substrate and the phase velocity of the waveguide mode. If in Figure 8, the waveguide width is a width in which the first-order mode cannot exist, only the zero-order mode can exist and thus, a single mode waveguide is provided. Also, the first-order mode is an asymmetrical mode and therefore, if the exciting electrodes and the surface acoustic wave waveguide are disposed so that the surface acoustic waves entering the surface acoustic wave waveguide 4 may be substantially symmetrical with respect to the center line of the waveguide, there will be provided a single mode waveguide even if the waveguide width is made into a width in which only the zero-order mode and the first-order mode can exist.

So, when the width of the surface acoustic wave waveguide 4 is made into a width in which only the zero-order mode can exist, or a width in which only the zero-order mode and the first-order mode can exist, surface acoustic waves symmetrical with respect to the center line of the waveguide propagate through the surface acoustic wave waveguide 4. When these surface acoustic waves propagate through the portions in which the electrode junction portions 6 are formed, the surface acoustic waves keep symmetry with respect to the center line of the waveguide because the electrode junction portions 6 are on the opposite sides of the surface acoustic wave waveguide 4, and the loss in the electrode junction portions 6 can be further suppressed.

The present embodiment is effective when, in any other waveguide than a single mode waveguide, the surface acoustic waves are distributed symmetrically with respect to the center line of the waveguide. Also, in the present embodiment, transmission lines may be connected to the electrode junction portions 6.

In the first and second embodiments as well, the surface acoustic wave waveguide may of course be a single mode waveguide.

In the first, second and third embodiments, the numbers of the electrode junction portions 6 are not limited to the numbers shown.

Also, in the first, second and third embodiments, the electrodes 2 and 3 for exciting the surface acoustic waves can be made into double electrodes (split electrodes) to thereby suppress the reflection of the surface acoustic waves in the electrodes 2 and 3 for exciting the surface acoustic waves, and make the characteristic of the device better.

Further, in the first, second and third embodiments, the substrate 1 is not restricted to piezoelectric material single crystal such as lithium niobate, but may be any material and structure having a parametric mixing effect, such as structure in which piezoelectric film is added, for example, onto a semiconductor or a glass substrate.

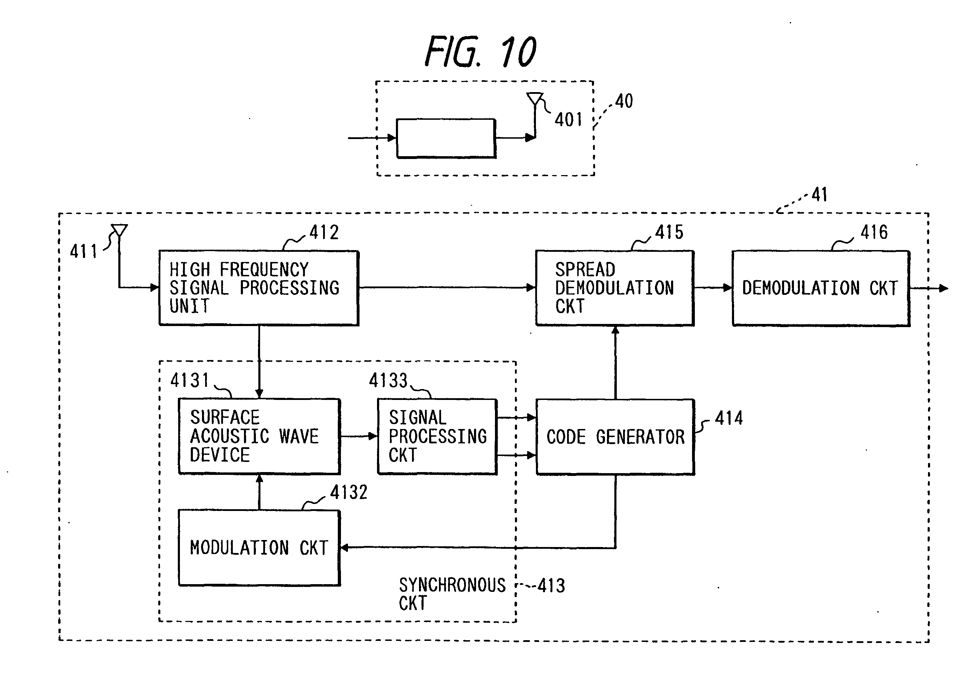

Figure 10 is a block diagram showing an example of a communication system using the surface acoustic wave device as described above. In Figure 10, the reference numeral 40 designates a transmitter. This transmitter spectrum-spread-modulates a signal to be transmitted by the use of a spread code and transmits it from an antenna 401. The transmitted signal is received and demodulated by a receiver 41. The receiver 41 is comprised of an antenna 411, a high frequency signal processing unit 412, a synchronous circuit 413, a code generator 414, a spread demodulation circuit 415 and a demodulation circuit 416. The received signal received by the antenna 411 is suitably filtered and amplified by the high frequency signal processing unit 412 and is outputted intactly as a transmission frequency band signal or is converted into a suitable intermediate frequency band signal and outputted. This signal is inputted to the synchronous circuit 413. The synchronous circuit 413 comprises a surface acoustic wave device 4131 as described in the embodiments of the present invention shown in Figures 1, 6 and 7, a modulation circuit 4132 for modulating a spread code for reference inputted from the code generator 414, and a signal processing circuit 4133 for processing a signal outputted from the surface acoustic wave device 4131 and outputting a spread code synchronous signal and a clock synchronous signal for the transmitted signal to the code generator 414.

An output signal from the high frequency signal processing unit 412 and an output signal from the modulation circuit 4132 are inputted to the surface acoustic wave device 4131, and the convolution calculation of the two input signals is effected. Assuming here that the spread code for reference inputted from the code generator 414 to the modulation circuit 4132 is a code resulting from the spread code transmitted from the transmission side having been time-reversed, a correlation peak is outputted in the surface acoustic wave device 4131 when a spread code component exclusively for synchronization included in the received signal and the spread code for reference coincide with each other on the waveguide of the surface acoustic wave device 4131.

In the signal processing circuit 4133, the correlation peak is detected from the signal inputted from the surface acoustic wave device 4131, and the amount of deviation of the code synchronization is calculated from the time from the code start of the spread code for reference till the correlation peak output, and a code synchronous signal and a clock signal are outputted to the code generator 414. After the establishment of synchronization, the code generator 414 generates a spread code in which the clock and spread code phase coincide with the spread code of the transmission side. This spread code is inputted to the spread demodulation circuit 415, and the signal before spread-modulated is restored to its original state. The signal outputted from the spread demodulation circuit 415 is a signal being modulated by a commonly used modulation system such as so-called frequency modulation or phase modulation and therefore, data demodulation is done by the demodulation circuit 416 well known to those skilled in the art.

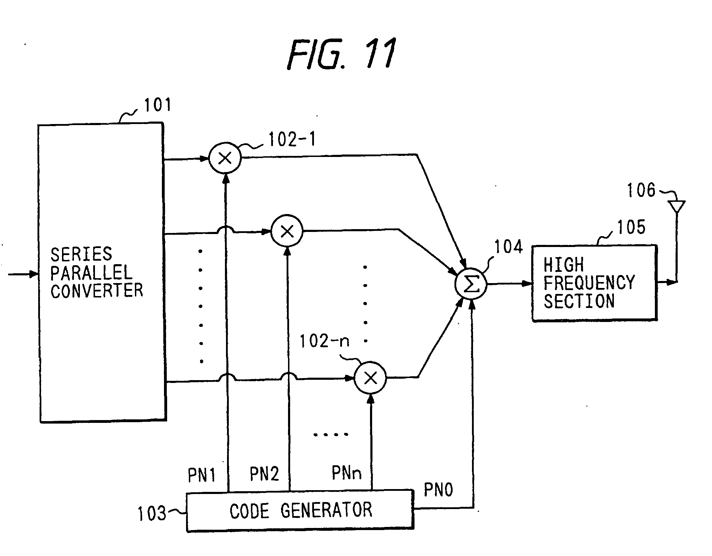

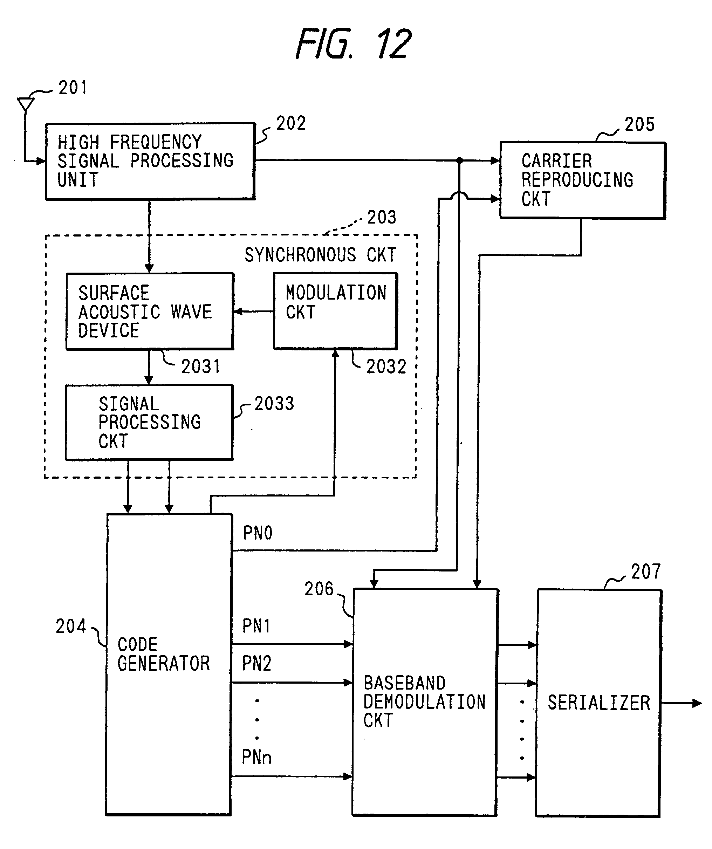

Figures 11 and 12 are block diagrams showing an example of the transmitter and receiver of another communication system using the surface acoustic wave device as described above. In Figure 11, the reference numeral 101 designates a series parallel converter for converting data inputted in series into n parallel data, the reference numerals 102-1-n denote a group of multipliers for multiplying the respective parallelconverted data by n spread codes outputted from the spread code generator, the reference numeral 103 designates a spread code generator for generating n different spread codes and a spread code exclusively for synchronization, the reference numeral 104 denotes an adder for adding the spread code exclusively for synchronization outputted from the spread code generator 103 to the n outputs of the group of multipliers 102-1-n, the reference numeral 105 designates a high frequency section for converting the output of the adder 104 into a transmission frequency signal, and the reference numeral 106 denotes a transmitting antenna.

In Figure 12, the reference numeral 201 designates a receiving antenna, the reference numeral 202 denotes a high frequency signal processing unit, the reference numeral 203 designates a synchronous circuit for catching and maintaining the synchronization with the spread code and clock of the transmission side the reference numeral 204 denotes a spread code generator for generating n+1 spread codes identical to the group of spread codes of the transmission side and a spread code for reference by a code synchronous signal and a clock signal inputted from the synchronous circuit 203, the reference numeral 205 designates a carrier reproducing circuit for reproducing a carrier wave signal from a carrier reproducing spread code outputted from the spread code generator 204 and the output of the high frequency signal processing unit 202, the reference numeral 206 denotes a base band demodulation circuit for effecting demodulation at a base band by the use of the output of the carrier reproducing circuit 205, the output of the high frequency signal processing unit 202 and n spread codes which are the output of the spread code generator 204, and the reference numeral 207 designates a serializer for serializing n parallel demodulation data which are the output of the base band demodulation circuit 206.

In the above-described construction, on the transmission side, input data are first converted into n parallel data by the series parallel converter 101. On the other hand, the spread code generator 103 generates n+1 different spread codes PN₀-PNₙ which are identical in code period. Of these spread codes, the spread code PN₀ is exclusively for synchronization and carrier reproduction and is not modulated by the aforementioned parallel data, but is directly inputted to the adder 104. The remaining n spread codes are modulated by n parallel data in the group of multipliers 102-1-n and are inputted to the adder 104.

The adder 104 linearly adds the inputted n+1 signals and outputs the added base band signal to the high frequency section 105. This base band signal is subsequently converted into a high frequency signal having a suitable central frequency by the high frequency section 105, and is transmitted from the transmitting antenna 106. On the reception side, the signal received by the receiving antenna 201 is suitably filtered and amplified by the high frequency signal processing unit 202 and is outputted intactly as a transmission frequency band signal or is converted into a suitable intermediate frequency band signal and outputted. This signal is inputted to the synchronous circuit 203.

The synchronous circuit 203 comprises a surface acoustic wave device 2031 as described in the embodiments of the present invention, a modulation circuit 2032 for modulating the spread code for reference inputted from the code generator 204, and a signal processing circuit 2033 for processing the signal outputted from the surface acoustic wave device 2031 and outputting a spread code synchronous signal and click synchronous signal for the transmitted signal to the spread code generator 204.

An output signal from the high frequency signal processing unit 202 and an output signal from the modulation circuit 2032 are inputted to the surface acoustic wave device 2031, and the convolution calculation of the two input signals is effected. Assuming here that the spread code for reference inputted from the code generator 204 to the modulation circuit 2032 is a code having resulted from the spread code exclusively for synchronization having been time-reversed, a correlation peak is outputted in the surface acoustic wave device 2031 when the spread code component exclusively for synchronization and the spread code for reference included in the received signal coincide with each other on the waveguide of the surface acoustic wave device 2031.

In the signal processing circuit 2033, the correlation peak is detected from the signal inputted from the surface acoustic wave device 2031, and the amount of deviation of code synchronization is calculated from the time from the start of the spread code for reference till the outputting of the correlation peak, and the code synchronous signal and clock signal are outputted to the spread code generator 204. After the establishment of synchronization, the spread code generator 204 generates a group of spread codes in which the clock and spread code phase coincide with the group of spread codes on the transmission side. Of this group of codes, the spread code PN₀ exclusively for synchronization is inputted to the carrier reproducing circuit 205.

In the carrier reproducing circuit 205, the transmitted frequency band which is the output of the high frequency signal processing unit 202 or the received signal converted into an intermediate frequency band is despread by the spread code PN₀ exclusively for synchronization and a carrier wave of the transmitted frequency band or the intermediate frequency band is reproduced. In the construction of the carrier reproducing circuit 205, use is made of a circuit utilizing, for example, a phase locked loop. The received signal is multiplied by the spread code PN₀ exclusively for synchronization in the multiplier. After the establishment of synchronization, the spread code exclusively for synchronization in the received signal and the clock and code phase of the spread code exclusively for synchronization for reference coincide with each other and the spread code exclusively for synchronization on the reception side is not modulated by data and is therefore despread by the multiplier and the component of the carrier wave appears in the output thereof.

This output is subsequently inputted to a band-pass filter are only the carrier wave component thereof is taken out and outputted. This output is then inputted to a well-known phase locked loop comprised of a phase detector, a loop filter and a voltage control oscillator, and a signal having a phase locked on the carrier wave component outputted from the band-pass filter is outputted as a reproduction carrier wave from the voltage control oscillator. The reproduced carrier wave is inputted to the base band demodulation circuit 206.

In the base band demodulation circuit 206, a base band signal is produced from the reproduced carrier wave and the output of the high frequency signal processing unit 202. This base band signal is divided into n signals, which are despread for each code divided channel by the group of spread codes PN₁-PNₙ which is the output of the spread code generator 204, and subsequently data demodulation is done. The demodulated n parallel demodulation data are converted into serial data by the serializer 207 and outputted.

The present embodiment is the case of binary modulation, but may be other modulation system such as orthogonal modulation.

As described above, according to the present invention, design is made such that the width of the portions in which the electrode junction portions electrically connected to the surface acoustic wave waveguide are in contact with the surface acoustic wave waveguide is made greater than 0.2 times the wavelength of the surface acoustic wave but not greater than 5 times the wavelength of the surface acoustic wave, whereby the reduction in output can be suppressed without increasing the propagation loss of the surface acoustic wave propagating on the surface acoustic wave waveguide and further, the yield can be increased.

While in the foregoing description, the width of the waveguide is about 2.5λₐ (in the case of this value, only the zero-order mode can exist in the waveguide), the present invention is not restricted thereto, but even when the width of the waveguide is a width in which only the zero-order mode can exist or a width in which the zero-order mode and the first-order mode can exist, if the waveguide, including the junction portions the output pads and the transmission lines, is disposed symmetrically with respect to the center line thereof and effectively functions as a waveguide of a single mode (the zero-order mode only), the width of the junction portions can be made greater than 0.2λₐ but not greater than 5λₐ to thereby suppress the reduction in output to the same degree as the above-described embodiments.

## Claims

1. A surface acoustic wave device comprising:
a substrate (1) having a piezoelectric property;
surface acoustic wave exciting means (2,3) formed on said substrate;
a waveguide (4) for guiding a surface acoustic wave excited by said exciting means;
output means (5) for taking out a signal generated by said waveguide; and
a junction portion (6) connecting said waveguide and said output means together;
**characterized in that** the width of that portion of said junction portion which is in contact with said waveguide is greater than 0.2 times but not greater than 5 times the wavelength of the surface acoustic wave excited by said exciting means.

2. A surface acoustic wave device according to Claim 1, **characterized in that** said output means is an output pad.

3. A surface acoustic wave device according to Claim 1, **characterized in that** said output means is a transmission line.

4. A surface acoustic wave device according to any of Claim 1 to 3, **characterized in that** a plurality of said junction portions are provided along said waveguide.

5. A surface acoustic wave device according to any of Claims 1 to 4, **characterized in that** said junction portion is provided on both sides of said waveguide substantially parallel to a direction in which the surface acoustic wave propagates.

6. A surface acoustic wave device according to Claim 5, **characterized in that** said junction portion is provided symmetrically with respect to the center line of said waveguide in the direction in which the surface acoustic wave propagates.

7. A surface acoustic wave device according to any of Claim 1 to 6, **characterized in that** the width of said waveguide is a width in which only the zero-order mode or only the zero-order mode and the first-order mode of the surface acoustic wave propagating through said waveguide can exist.

8. A surface acoustic wave device according to any of Claims 1 to 7, **characterized in that** the number of said exciting means is at least two, and said waveguide can propagate therethrough surface acoustic waves excited by the different exciting means in opposite directions.

9. A communication system for transmitting a spread spectrum signal having:
a transmitter (40) for transmitting the spread spectrum signal; and
a receiver (41) having a surface acoustic wave device (4131) for obtaining the convolution signal of the inputted spread spectrum signal and a reference signal;
**characterized in that** said surface acoustic wave device is that of Claim 8, at least one exciting means excites a surface acoustic wave corresponding to the received spread spectrum signal, at least one other exciting means excites a surface acoustic wave corresponding to the reference signal, and said waveguide guides the surface acoustic wave corresponding to the spread spectrum signal and the surface acoustic wave corresponding to the reference signal in opposite directions.

## Patentansprüche

1. Akustische Oberflächenwellenanordnung mit
einem Substrat (1) mit einer piezoelektrischen Eigenschaft,
auf dem Substrat ausgebildeten Anregungseinrichtungen für akustische Oberflächenwellen (2, 3),
einem Wellenleiter (4) zum Leiten einer durch die Anregungseinrichtungen angeregten akustischen Oberflächenwelle,
Ausgangseinrichtungen (5) zur Entnahme eines durch den Wellenleiter erzeugten Signals und
einem den Wellenleiter und die Ausgangseinrichtungen miteinander verbindenden Verbindungselement,
**dadurch gekennzeichnet, dass** die Breite des Teils des Verbindungselements, der in Kontakt mit dem Wellenleiter ist, größer als 0,2-mal, aber nicht größer als 5-mal die Wellenlänge der akustischen Oberflächenwelle ist, die durch die Anregungseinrichtungen angeregt ist.

2. Akustische Oberflächenwellenanordnung nach Anspruch 1, **dadurch gekennzeichnet, dass** die Ausgangseinrichtung ein Ausgangsanschlussfeld ist.

3. Akustische Oberflächenwellenanordnung nach Anspruch 1, **dadurch gekennzeichnet, dass** die Ausgangseinrichtung eine Übertragungsleitung ist.

4. Akustische Oberflächenwellenanordnung nach einem der Ansprüche 1 bis 3, **dadurch gekennzeichnet, dass** eine Vielzahl der Verbindungselemente entlang dem Wellenleiter bereitgestellt ist.

5. Akustische Oberflächenwellenanordnung nach einem der Ansprüche 1 bis 4, **dadurch gekennzeichnet, dass** das Verbindungselement bei beiden Seiten des Wellenleiters im Wesentlichen parallel zu einer Richtung bereitgestellt ist, in der sich die akustische Oberflächenwelle ausbreitet.

6. Akustische Oberflächenwellenanordnung nach Anspruch 5, **dadurch gekennzeichnet, dass** das Verbindungselement symmetrisch in Bezug auf die Mittellinie des Wellenleiters in der Richtung bereitgestellt ist, in der sich die akustische Oberflächenwelle ausbreitet.

7. Akustische Oberflächenwellenanordnung nach einem der Ansprüche 1 bis 6, **dadurch gekennzeichnet, dass** die Breite des Wellenleiters ein Breite ist, in der lediglich der Mode nullter Ordnung oder lediglich der Mode nullter Ordnung und der Mode erster Ordnung der sich durch den Wellenleiter ausbreitenden akustischen Oberflächenwelle existieren können.

8. Akustische Oberflächenwellenanordnung nach einem der Ansprüche 1 bis 7, **dadurch gekennzeichnet, dass** die Anzahl der Anregungseinrichtungen zumindest zwei beträgt und der Wellenleiter durch die unterschiedlichen Anregungseinrichtungen angeregte akustische Oberflächenwellen in entgegengesetzte Richtungen durch sich verbreiten kann.

9. Kommunikationssystem zur Übertragung eines Spreizspektrumsignals, mit
einer Übertragungsvorrichtung (40) zur Übertragung des Spreizspektrumsignals und
einer Empfangsvorrichtung (41) mit einer akustischen Oberflächenwellenanordnung (4131) zum Erhalten des Faltungssignals des zugeführten Spreizspektrumsignals und eines Referenzsignals,
**dadurch gekennzeichnet, dass** die akustische Oberflächenwellenanordnung die nach Anspruch 8 ist, zumindest eine Anregungseinrichtung eine akustische Oberflächenwelle entsprechend dem empfangenen Spreizspektrumsignal anregt, zumindest eine andere Anregungseinrichtung eine akustische Oberflächenwelle entsprechend dem Referenzsignal anregt und der Wellenleiter die dem Spreizspektrumsignal entsprechende akustische Oberflächenwelle und die dem Referenzsignal entsprechende akustische Oberflächenwelle in entgegengesetzte Richtungen leitet.

## Revendications

1. Dispositif à ondes acoustiques de surface comportant :
un substrat (1) ayant une propriété piézo-électrique ;
un moyen (2, 3) d'excitation d'une onde acoustique de surface formé sur ledit substrat ;
un guide d'onde (4) destiné à guider une onde acoustique de surface excitée par ledit moyen d'excitation ;
un moyen de sortie (5) destiné à prélever en sortie un signal généré par ledit guide d'onde ; et
une partie de jonction (6) connectant ledit guide d'onde et ledit moyen de sortie l'un à l'autre ;
**caractérisé en ce que** la largeur de la partie de ladite partie de jonction qui est en contact avec ledit guide d'onde est supérieure à 0,2 fois, mais non supérieure à 5 fois la longueur d'onde de l'onde acoustique de surface excitée par ledit moyen d'excitation.

2. Dispositif à ondes acoustiques de surface selon la revendication 1, **caractérisé en ce que** ledit moyen de sortie est un plot de sortie.

3. Dispositif à ondes acoustiques de surface selon la revendication 1, **caractérisé en ce que** ledit moyen de sortie est une ligne de transmission.

4. Dispositif à ondes acoustiques de surface selon l'une quelconque des revendications 1 à 3, **caractérisé en ce que** plusieurs desdites parties de jonction sont prévues le long dudit guide d'onde.

5. Dispositif à ondes acoustiques de surface selon l'une quelconque des revendications 1 à 4, **caractérisé en ce que** ladite partie de jonction est prévue sur les deux côtés dudit guide d'onde sensiblement parallèle à une direction dans laquelle l'onde acoustique de surface se propage.

6. Dispositif à ondes acoustiques de surface selon la revendication 5, **caractérisé en ce que** ladite partie de jonction est prévue symétriquement par rapport à l'axe central dudit guide d'onde dans la direction dans laquelle l'onde acoustique de surface se propage.

7. Dispositif à ondes acoustiques de surface selon l'une quelconque des revendications 1 à 6, **caractérisé en ce que** la largeur dudit guide d'onde est une largeur dans laquelle seul le mode d'ordre zéro ou seul le mode d'ordre zéro et le mode de premier ordre de l'onde acoustique de surface se propageant dans ledit guide d'onde peuvent exister.

8. Dispositif à ondes acoustiques de surface selon l'une quelconque des revendications 1 à 7, **caractérisé en ce que** le nombre desdits moyens d'excitation est d'au moins deux, et ledit guide d'onde peut propager à travers lui des ondes acoustiques de surface excitées par les différents moyens d'excitation dans des sens opposés.

9. Système de communication destiné à transmettre un signal à spectre étalé, ayant :
un émetteur (40) destiné à émettre le signal à spectre étalé ; et
un récepteur (41) ayant un dispositif (4131) à onde acoustique de surface pour l'obtention du signal obtenu par convolution du signal à spectre étalé d'entrée et d'un signal de référence ;
**caractérisé en ce que** ledit dispositif à ondes acoustiques de surface est celui de la revendication 8, au moins un moyen d'excitation excite une onde acoustique de surface correspondant au signal à spectre étalé reçu, au moins un autre moyen d'excitation excite une onde acoustique de surface correspondant au signal de référence, et ledit guide d'onde guide l'onde acoustique de surface correspondant au signal à spectre étalé et l'onde acoustique de surface correspondant au signal de référence dans des sens opposés.
